# EUROPÄISCHE PATENTANMELDUNG

(11) **EP 1 512 990 A1**
(43) Veröffentlichungstag der Anmeldung: **09.03.2005**
(21) Anmeldenummer: 03018487.3
(22) Anmeldetag: 14.08.2003
(51) Int. Cl.: G01T 1/29

(54) **Strahl-Eintrittsfenster für Strahlungsdetektoren**

(71) Anmelder: KEMMER, Josef, Dr., D-85764 Oberschleissheim (DE)
(72) Erfinder: KEMMER, Josef, Dr., D-85764 Oberschleissheim (DE)
(74) Vertreter: Niederkofler, Oswald A., Dipl.-Phys.

(57) **Zusammenfassung**

Die Erfindung betrifft ein Strahl-Eintrittsfenster für einen Strahlungsdetektor mit einem Halbleitergrundkörper niedriger Dotierung von einem ersten Leitungstyp, auf dessen mindestens einer Oberfläche mindestens eine dünne hochdotierte Schicht von einem dem ersten Leitungstyp entgegengesetzten zweiten Leitungstyp angeordnet ist, wobei die Schicht des zweiten Leitungstyps als Inversionsschicht ausgebildet ist. Ferner betrifft die Erfindung einen entsprechenden Strahlungsdetektor sowie die Kombination eines derartigen Strahlungsdetektors mit einem Szintillator.

## Beschreibung

Die Erfindung betrifft ein Strahl-Eintrittsfenster für einen Strahlungsdetektor gemäß dem Oberbegriff des Patentanspruchs 1. Ferner betrifft die Erfindung einen entsprechenden Strahlungsdetektor sowie die Kombination eines derartigen Strahlungsdetektors mit einem Szintillator.

Bekannte Halbleiterstrahlungsdetektoren zum Nachweis elektromagnetischer und ionisierender Strahlung weisen in der Regel einen niedrig dotierten Grundkörper eines ersten Leistungstyps, auf dessen einer Hauptoberfläche sich eine hoch dotierte sehr dünne Schicht eines zweiten Leitungstyps befindet, auf. Meist ist diese Schicht noch mit einer Metallelektrode versehen. Eine solche Anordnung, die auch als abrupter, asymmetrischer pn-Übergang bezeichnet wird, hat die Eigenschaft, daß sich bei Betrieb in Sperrichtung die Raumladungszone überwiegend in den niedrig dotierten Grundkörper ausbreitet. Die Dicke der hoch dotierten Schicht, die zusammen mit der Metallelektrode als sog. Strahl-Eintrittsfenster bzw. als Totschicht des Detektors bezeichnet wird, sollte möglichst spannungsunabhängig und möglichst gering sein.

Die zu messende Strahlung muß dabei zunächst das Strahl-Eintrittsfenster passieren, bevor sie die ladungsträgerfreie Raumladungszone erreicht, in der sie nachgewiesen werden kann. Bei der Absorption der Strahlung werden Elektron/Loch-Paare gebildet, deren Anzahl der Energie bzw. der Intensität der Strahlung proportional ist. Im Idealfall würden alle Ladungsträger registriert und damit wäre eine präzise Bestimmung der Energie bzw. der Intensität der Strahlung möglich.

In der Praxis bekannter Halbleiterstrahlungsdetektoren wird jedoch ein geringer Teil der Strahlung im Strahl-Eintrittsfenster absorbiert und ein Teil der Ladungsträger geht verloren und damit wird das Meßsignal verfälscht. Das Problem wird noch dadurch verschärft, daß die Ineffizienz des Strahl-Eintrittsfensters nicht über die gesamte Dicke konstant ist. Das führt dazu, daß Ladungsträger, die im Strahl-Eintrittsfenster generiert werden, zum Teil in die Raumladungszone gelangen können und damit eine zusätzliche Signalverschmierung verursachen.

Diese Effekte sind besonders bei Strahlung kurzer Reichweite, wie z.B. niederenergetischer Röntgenstsrahlung sehr störend, da sie das gemessene Spektrum stark beeinflussen. Für das Absorptionsverhalten des Strahl-Eintrittsfensters gibt es zwei Grenzfälle: zum einen, daß alle dort generierten Ladungsträger registriert werden, zum andern, daß alle dort generierten Ladungsträger verloren sind. In beiden Fällen sieht die Form des gemessenen Spektrums ähnlich aus. Der wesentliche Unterschied besteht im Absolutwert der gemessenen Ladungsträger, deren Menge von der Fensterdicke abhängig ist.

In der Praxis läßt sich keiner dieser Grenzfälle realisieren. Es gibt kein Strahl-Eintrittsfenster bzw. keine Totschicht, die komplett tot ist und es gibt kein Strahl-Eintrittsfenster, welches vollständig zum Strahlungsnachweis beiträgt. Häufig werden im Stand der Technik die Strahl-Eintrittsfenster mit Hilfe der Dotierung durch Ionenimplantation hergestellt. In diesem Fall hat man keine abrupte Dotierung, sondern ein annähernd gaußförmiges Profil. Abhängig vom Ort der Erzeugung und von der Lebensdauer der Minioritätsladungsträger gelangt ein Teil der im Fenster generierten Ladung in die Raumladungszone und wird dort registriert.

Eine weitere Problematik ergibt sich aus den elektronischen Zuständen im Oberflächenbereich des Halbleiters, den sogenannten Grenzflächenzuständen. Durch das Einfangen von Signalladungen können sie zur Verfälschung des Spektrums beitragen.

Die vorliegende Erfindung möchte hier Abhilfe schaffen.

Die Erfindung erreicht dieses Ziel durch die Gegenstände der Ansprüche 1, 7 und 14. Beispiele für bevorzugte Ausführungen der Erfindung sind in den jeweils abhängigen Ansprüchen angegeben.

Erfindungsgemäß ist u.a. nun erkannt worden, daß als kostengünstige Alternative zur Dotierung mittels Ionenimplantation, eine Inversionsschicht eingesetzt werden kann. Inversions- und Akkumulationsschichten können bekanntermaßen auf Halbleitern als Sperrschichten bzw. als nicht sperrende Kontakte genutzt werden. Derartige Anordnungen sind beispielsweise in der EP 0 585 263 A1 für den Aufbau von Streifendetektoren beschrieben, dienen dort aber nicht als Strahl-Eintrittsfenster.

Eine Inversionsschicht erhält man z.B. unter einer MOS-Struktur (Metall-Oxid-Halbleiter) auf einem n-Typ Silicium, wenn die Metallelektrode negativ gepolt wird. Aufgrund der negativen Spannung kommt es zunächst zu einer Verarmungsschicht und dann zu einer Anreicherung von Minoritätsladungsträgern d.h. Löchern unter dem Oxid und damit zu einer Inversion des Leitungstyps.

Wenn diese Löcherschicht durch geeignete Maßnahmen kontaktiert wird, dann kann durch Anlegen einer negativen Spannung eine Raumladungszone, wie in einem metallurgischen pn-Übergang erzeugt werden. Dabei dehnt sich die Raumladungszone nur in den Halbleitergrundkörper aus. Die Inversionsschicht verhält sich demnach wie eine sehr dünne hochdotierte Schicht des zweiten Leitungstyps. Für einfallende Strahlung stellt die Kombination von Metallelektrode und Oxidschicht das Strahl-Eintrittsfenster dar. Unter der Annahme, daß die Absorption dieser Schichten homogen ist, erhält man damit nach einem Aspekt der Erfindung das gewünschte erfindungsgemäße homogene Strahl-Eintrittsfenster.

Aufgrund der hohen Konzentration der Minoritätsladungsträger in der Inversionsschicht spielen Veränderungen in der Besetzung der Grenzflächenzustände keine Rolle mehr. Damit erniedrigt sich sowohl der Strombeitrag aus der Oberfläche als auch der Einfluß der Grenzflächen auf die Form des Spektrums.

Eine bevorzugte Ausgestaltung der Erfindung stellt eine Schicht aus einem Dielektrikum dar, das bereits eine hohe Konzentration an negativer Ladung aufweist. Wird ein solches Dielektrikum anstelle der Oxidschicht auf den Halbleitergrundkörper der n-Typ Leitfähigkeit aufgebracht, so benötigt man keine Metallelektrode und keine zusätzliche negative Spannung mehr, da bereits durch die im Dielektrikum vorhandene negative Ladung eine Inversions-schicht generiert wird.

Durch die Vermeidung einer zusätzlichen Metallschicht, ist es möglich, die Dicke des Strahl-Eintrittsfensters zu verringern und damit die Transmission zu erhöhen. Die Totschicht wird dann ausschließlich durch die Eigenschaften und die Dicke des Dielektrikums bestimmt.

Ohne Beschränkung des allgemeinen Erfindungsgedankens sind auch andere Schichten nutzbar, insbesondere auch thermische Oxide auf p-Silicium, da diese immer eine positive Ladung aufweisen, deren Konzentration durch geeignete Maßnahmen auf das erforderliche Maß erhöht werden kann. Insbesondere ist es auch möglich, in Analogie zur Vorderseite, Akkumulationsschichten auf der Detektorrückseite als niederohmige Kontakte zu nutzen.

Weitere Aspekte der Erfindung werden nachstehend ohne Beschränkung des allgemeinen Erfindungsgedankens anhand von Ausführungsbeispielen - in denen hochreines n-Typ Silicium, vorzugsweise mit der Orientierung (100) als Grundkörper gewählt wurde - unter Bezugnahme auf die Zeichnungen exemplarisch beschrieben, auf die im übrigen hinsichtlich der Offenbarung aller im Text nicht näher erläuterten erfindungsgemäßen Einzelheiten ausdrücklich verwiesen wird. Es zeigen:
Fig. 1 einen Strahlungsdetektor mit einer MOS Struktur und einer Inversionsschicht als Strahl-Eintrittsfenster, sowie einer p+ Implantation und Metallelektroden zur Kontaktierung nach einem Ausführungsbeispiel der Erfindung;
Fig. 2 einen Strahlungsdetektor mit einem negativ geladenen Dielektrikum im Strahl-Eintrittsfenster und der darunter befindlichen Inversionsschicht, sowie einer p+ Implantation und Metallkontakten zur Inversionsschicht nach einem Ausführungsbeispiel der Erfindung;
Fig. 3 einen Strahlungsdetektor ähnlich wie in Fig. 2, jedoch ohne die p+ Implantation im Randbereich sowie mit einer Akkumulationsschicht als niederohmigen Kontakt auf der Rückseite nach einem weiteren Ausführungsbeispiel der Erfindung;
Fig. 4 einen Strahlungsdetektor wie in Fig. 3, jedoch mit Guardringen zum Abbau der elektrischen Felder im Randbereich nach einem weiteren Ausführungsbeispiel der Erfindung;
Fig. 5 einen Strahlungsdetektor der an einen Szintillator gekoppelt ist nach einem Ausführungsbeispiel der Erfindung; und
Fig. 6 einen Strahlungsdetektor vom Typ eines Driftdetektors, der an einen Szintillator gekoppelt ist, nach einem weiteren Ausführungsbeispiel der Erfindung.

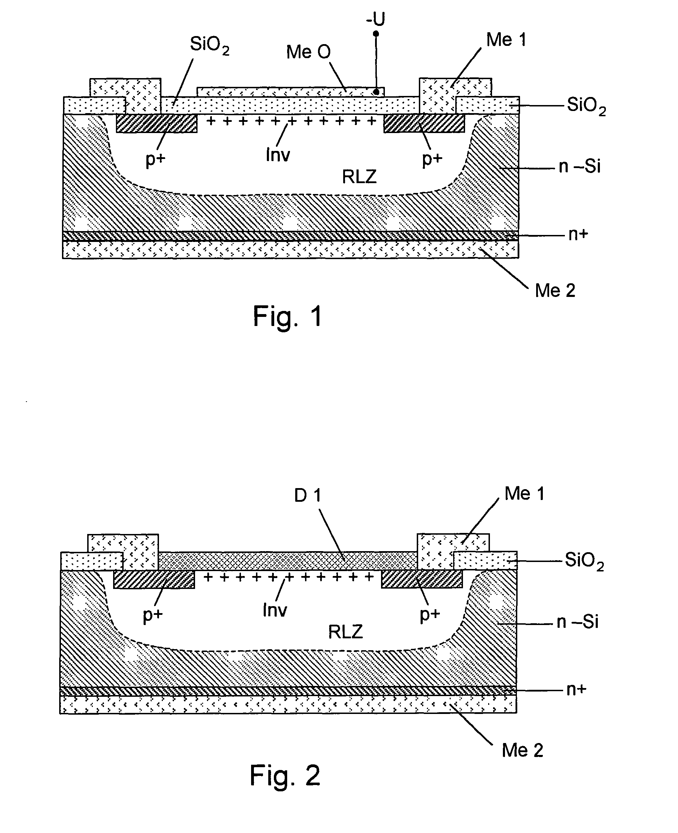

Im ersten Ausführungsbeispiel nach Fig. 1 ist ein Detektor mit einer Inversionsschicht Inv unter Nutzung einer MOS Anordnung abgebildet. Durch eine negative Spannung an einer Metallelektrode Me 0 wird unter dem Oxid SiO₂ eine aus Löchern bestehende sehr dünne Inversionsschicht Inv generiert. Diese wird mit Hilfe der Kontakte Me 1 negativ gepolt und erzeugt eine Raumladungszone RLZ. Auf der Rückseite befindet sich eine n+-Dotierung und darüber ein Metallkontakt Me 2. Elektron/Loch-Paare, die durch absorbierte Strahlung generiert werden, wandern zu den Elektroden und werden dort als Signale registriert.

In einem zweiten Ausführungsbeispiel nach Fig. 2 ist zur Erzeugung einer Inversionsschicht Inv auf der Strahleintrittseite eine Dielektrikum D 1 mit fixer negativer Ladung aufgebracht. Dadurch entfällt die Metallelektrode Me 0. Die Spannung zur Inversionsschicht Inv wird wieder durch Metallelektrode Me 1 zugeführt. Als Rückkontakt dient eine Elektrode Me 2 auf einer n+dotierten Schicht.

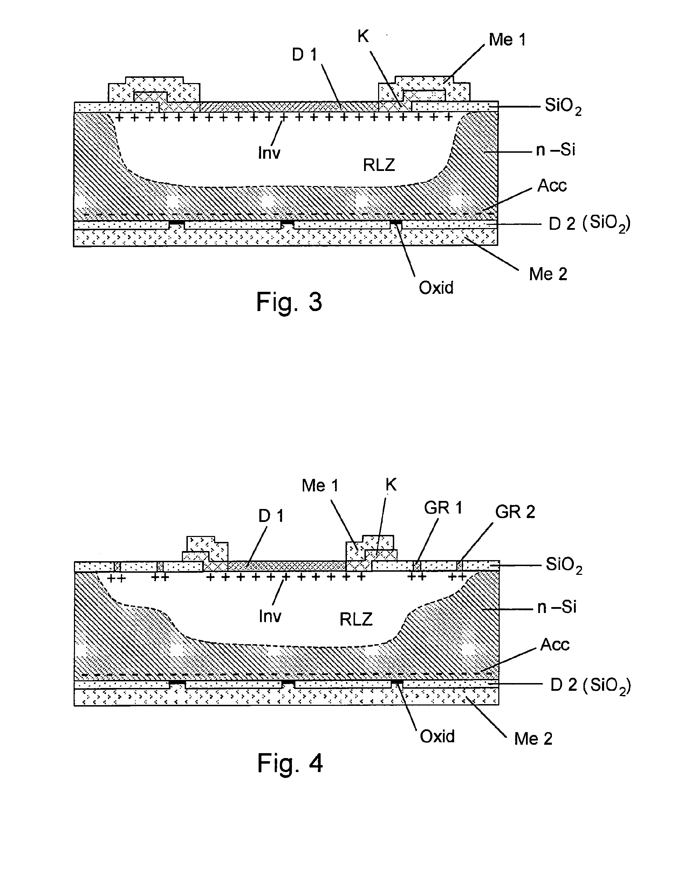

Das dritte Ausführungsbeispiel nach Fig. 3 zeigt auf der Vorderseite wieder ein Dielektrikum D 1 zur Erzeugung der Inversionsschicht Inv. Die Metallisierung der Inversionsschicht wird durch eine Metallschicht Me 1, vorzugsweise eine aufgedruckte Metallpaste erzielt, die nach thermischer Nachbehandlung durch das Dielektrikum diffundiert und dieses im Bereich K leitfähig macht. Auf der Rückseite befindet sich eine Akkumulationsschicht Acc, die durch ein Dielektrikum D 2 mit positiver fixer Ladung, wie z.B. durch ein thermisches Oxid, erzeugt wird. Zur Kontaktierung der Akkumulationsschicht Acc sind Öffnungen im diesem Dielektrikum vorgesehen, die jedoch mit einer sehr dünnen natürlichen Oxidschicht (Oxid) bedeckt sind. Der Kontakt zu einer aufgebrachten Metall-elektrode Me 2 und der Akkumulationsschicht Acc wird durch diese Oxidschicht hindurch über den Tunneleffekt zustandegebracht.

Durch den Einsatz eines geeigneten Dielektrikums D 2 ist es auch auf dieser Seite möglich, aufgedruckte Metallpasten zur Kontaktierung zu benutzen. Damit zeichnet sich insbesondere dieses Ausführungsbeispiel dadurch aus, daß es technologisch sehr einfach und damit sehr billig herzustellen ist.

Ein viertes Ausführungsbeispiel in Fig. 4 unterscheidet sich vom vorhergehenden lediglich dadurch, daß zum Spannungsabbau im Randbereich Guardringe GR 1 und GR 2 vorgesehen sind, die durch den Puchthrough-Effekt aktiviert werden.

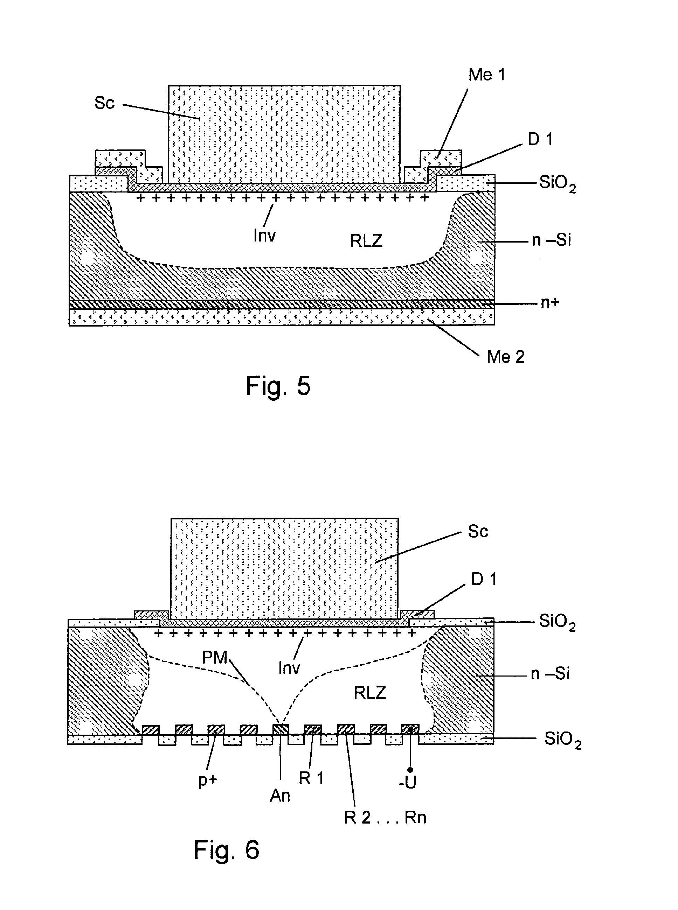

Ein fünftes Ausführungsbeispiel nach Fig. 5 zeigt einen Strahlungsdetektor mit einem optisch transparenten Dielektrikum D 1 zur Erzeugung der Inversionsschicht Inv, das gleichzeitig als Antifreflexschicht zur optischen Ankopplung an einen Szintillator Sc dient. Eine solche Kombination ist zum Nachweis höherenergetischer Röntgenstrahlung bzw. Gammstrahlung geeignet. Diese wird im Szintillator Sc absorbiert und erzeugt dort Photonen, die in der Raumladungs-zone RLZ des Halbleiterdetektors nachgewiesen werden können.

In einem sechstes Ausführungsbeispiel nach Fig. 6 ist im Gegensatz zu Fig. 5 der Detektor vom Driftkammertyp. Dadurch besteht die Möglichkeit, auf die Elektroden auf der Szintillatorseite zu verzichten und die Betriebsspannungen von der Rückseite an der Anode An und dem äußerstem Driftring Rn zuzuführen. Dies ist besonders vorteilhaft bei der Zusammensetzung von Arrays aus solchen Zellen zu bildgebenden Systemen, wie z.B. zu einer Angerkamera für den Einsatz in der Medizintechnik.

Zur Erhöhung der Spannungsfestigkeit sind in den ersten drei Ausführungsbeispielen der Einfachheit halber die Metallelektroden auf der Strahleintrittseite als "Fieldplates" ausgebildet. Ohne Einschränkung des Erfindungsgedankens können selbstverständlich auch andere an sich bekannte Verfahren, wie Guardringe oder Widerstandsschichten zum Einsatz kommen. Zu ihrer Realisierung können die bekannten Verfahren wie z.B. die Ionenimplantation oder vorteilhafterweise auch die erfindungsgemäße Inversionsschicht selbst, wie im vierten Ausführungsbeipiel gezeigt, benutzt werden.

Die Wahl der Ausführungsbeispiele wurde bewußt so getroffen, daß der Erfindungsgedanke klar zur Geltung kommt. Selbstverständlich können die erfindungsgemäßen Inversionsschichten auch bei komlexen Detektoren wie CCDs, Streifendetektoren oder Driftdetektoren als Strahl-Eintrittsfenster zum Einsatz kommen. Insbesondere können auch andere als die beschriebenen dielektrischen Schichten Verwedung finden und es sind auch Kombinationen mit anderen technologischen Verfahren möglich. Besonders interessant ist auch die Verwendung von p-Typ Silicium als Basismaterial für den Strahlungsdetektor. In diesem Fall erhält man mit den gleichen Dielektrika Oberflächenladungen des entgegengesetzten Leitungstyps, also z. B. anstelle einer Inversionsschicht eine Akkumulationsschicht und umgekehrt.

## Patentansprüche

1. Strahl-Eintrittsfenster für einen Strahlungsdetektor mit einem Halbleitergrundkörper niedriger Dotierung von einem ersten Leitungstyp, auf dessen mindestens einer Hauptoberfläche mindestens eine dünne hochdotierte Schicht von einem dem ersten Leitungstyp entgegengesetzten zweiten Leitungstyp angeordnet ist, **dadurch gekennzeichnet, daß** die Schicht des zweiten Leitungstyps als Inversionsschicht ausgebildet ist.

2. Strahl-Eintrittsfenster nach Anspruch 1, **dadurch gekennzeichnet, daß** zur Bildung der Inversionsschicht eine MOS-Struktur aufgebracht ist.

3. Strahl-Eintrittsfenster nach Anspruch 1 oder 2, **dadurch gekennzeichnet, daß** zur Bildung der Inversionsschicht ein Dielektrikum mit fixer Ladung vom gleichen Leitfähigkeitstyp wie der Grundkörper aufgebracht ist.

4. Strahl-Eintrittsfenster nach einem der Ansprüche 1 bis 3, **dadurch gekennzeichnet, daß** zur Kontaktierung der Inversionsschicht lokale Dotierungen vom Leitungstyp der Inversionsschicht im Grundkörper vorgesehen sind.

5. Strahl-Eintrittsfenster nach Anspruch 4, **dadurch gekennzeichnet, daß** die lokalen Dotierungen durch Ionenimplantation oder Diffusion hergestellt sind und mit einer leitfähigen Elektrode verbunden sind.

6. Strahl-Eintrittsfenster nach einem der Ansprüche 1 bis 3, **dadurch gekennzeichnet, daß** zur Kontaktierung der Inversionsschicht eine Leiterpaste lokal auf dem Dielektrikum aufgebracht ist und thermisch behandelt wurde.

7. Strahlungsdetektor mit einem Strahl-Eintrittsfenster nach einem der vorstehenden Ansprüche, wobei zum Spannungsabbau Fieldplates oder Guardstrukturen im Randbereich der Inversionsschicht integriert sind.

8. Strahlungsdetektor nach Anspruch 7, **dadurch gekennzeichnet, daß** die Guardstrukturen mit Hilfe des Dielektrikums herstellbar sind.

9. Strahlungsdetektor nach Anspruch 7 oder 8, **dadurch gekennzeichnet, daß** das Dielektrikum im Randbereich in Form konzentrischer Ringe auf einem passivierenden Oxid aufgebracht ist.

10. Strahlungsdetektor nach einem der Ansprüche 7 bis 9, **dadurch gekennzeichnet, daß** zur Kontaktierung der Rückseite eine hoch dotierte Schicht der ersten Leitfähigkeit und darauf befindliche Metallelektroden angeordnet sind.

11. Strahlungsdetektor nach einem der Ansprüche 7 bis 10, **dadurch gekennzeichnet, daß** zur Kontaktierung der Rückseite eine Akkumulationsschicht und leitfähige Kontakte zu dieser Akkumulationsschicht vorgesehen sind.

12. Strahlungsdetektor nach Anspruch 11, **dadurch gekennzeichnet, daß** zur Erzeugung der Akkumulationsschicht ein Dielektrikum mit einer fixen Ladung vom anderen Leitungstyp als der Grundkörper vorgesehen ist.

13. Strahlungsdetektor nach einem der Ansprüche 7 bis 12, **dadurch gekennzeichnet, daß** bei einem Grundkörper aus n-Silicium ein thermisches Oxid als Dielektrikum verwendet wird.

14. Kombination von mindestens einem Strahlungsdetektor nach einem der Ansprüche 7 bis 13 mit einem Szintillator, wobei das zur Bildung der Inversionsschicht genutzte Dielektrikum gleichzeitig als Antifreflexschicht und/oder optischer Koppler zwischen dem Szinitillator und dem Detektor fungiert.

15. Kombination nach Anspruch 14, **dadurch gekennzeichnet, daß** der Detektor vom Driftkammertyp ist und die Betriebsspannungen von der Rückseite zugeführt werden.
